# EUROPÄISCHE PATENTANMELDUNG

(11) **EP 4 064 491 A1**
(43) Veröffentlichungstag der Anmeldung: **28.09.2022**
(21) Anmeldenummer: 21164637.7
(22) Anmeldetag: 24.03.2021
(51) Int. Cl.: H02H 3/40, G01R 31/08, H02H 7/22, H02H 7/26

(54) **VERFAHREN UND EINRICHTUNG ZUM BESTIMMEN EINER FEHLERIMPEDANZ**

(71) Anmelder: Siemens Aktiengesellschaft, 80333 München (DE)
(72) Erfinder: Blumschein, Jörg, 14165 Berlin (DE); Dzienis, Cezary, 14624 Dallgow-Döberitz (DE)

(57) **Zusammenfassung**

Die Erfindung betrifft ein Verfahren zum Bestimmen einer Fehlerimpedanz, bei dem im Fall eines Fehlers bezüglich eines Schutzobjektes (10) eines elektrischen Energieversorgungsnetzes an einem Ende (11a) des Schutzobjektes während des Fehlers auftretende Ströme und Spannungen erfasst und zur Bestimmung der Fehlerimpedanz herangezogen werden.

Um die Bestimmung der Fehlerimpendanz mit höherer Genauigkeit durchführen zu können, wird vorgeschlagen, dass ein während des Fehlers gemessener Spannungsverlauf (40) durch einen korrigierten Spannungsverlauf (41) ersetzt wird, und die Fehlerimpedanz unter Verwendung des korrigierten Spannungsverlaufs (41) bestimmt wird.

Die Erfindung betrifft auch eine Einrichtung (61) zur Durchführung eines solchen Verfahrens.

## Beschreibung

Die Erfindung betrifft ein Verfahren zum Bestimmen einer Fehlerimpedanz, bei dem im Fall eines Fehlers bezüglich eines Schutzobjektes eines elektrischen Energieversorgungsnetzes an einem Ende des Schutzobjektes während des Fehlers auftretende Ströme und Spannungen erfasst und zur Bestimmung der Fehlerimpedanz herangezogen werden.

Die Erfindung betrifft auch eine entsprechende Einrichtung zum Bestimmen einer Fehlerimpedanz.

Zur Überwachung von Schutzobjekten, z.B. Freileitungen und Kabeln, elektrischer Energieversorgungsnetze werden sogenannte Schutzgeräte eingesetzt, um unzulässige Betriebszustände der jeweils überwachten Leitung, die beispielsweise durch Kurzschlüsse oder Erdkurzschlüsse hervorgerufen sein können, zu erkennen und automatisch abzuschalten. Hierzu nimmt das elektrische Schutzgerät üblicherweise Messwerte auf, beispielsweise Strom- und/oder Spannungsmesswerte, die den Betriebszustand der Leitung charakterisieren. Zur Ausführung seiner Schutzfunktion, wertet das Schutzgerät daraufhin die Messwerte unter Ausführung eines sogenannten Schutzalgorithmus, also einer Berechnungs- und/oder logischen Verknüpfungsvorschrift zur Auswertung der aufgenommenen Messwerte, aus und erzeugt in Abhängigkeit vom Ergebnis der Auswertung gegebenenfalls ein Auslösesignal, das einen mit dem Schutzgerät in Verbindung stehenden Leistungsschalter zum Öffnen seiner Schaltkontakte veranlasst, um die fehlerbehaftete Leitung vom übrigen Energieversorgungsnetz abzutrennen.

Ein häufig zur Überwachung von Leitungen elektrischer Energieversorgungsnetze eingesetzter Schutzalgorithmus arbeitet nach dem sogenannten Distanzschutzverfahren, bei dem aus Strom- und Spannungsmesswerten in einer komplexen Zahlenebene liegende Impedanzwerte berechnet werden und überprüft wird, ob die Impedanzwerte innerhalb eines - auch als Auslösepolygon bezeichneten - vorgegebenen Auslösebereiches liegen. Sofern die Impedanzwerte innerhalb dieses vorgegebenen Auslösebereiches liegen, stellt das Distanzschutzgerät einen unzulässigen Betriebszustand an der von ihm überwachten Leitung des elektrischen Energieversorgungsnetzes fest und sendet ein Auslösesignal an einen oder mehrere die Leitung begrenzende Leistungsschalter, um die fehlerhafte Leitung vom restlichen Energieversorgungsnetz zu trennen. Die Fehlerimpedanz (umgerechnet auf die Fehlerdistanz) wird bei diesem Verfahren dazu verwendet, um festzustellen, ob der erfasste Fehler tatsächlich auf dem überwachten Schutzobjekt liegt. Dazu müssen die Länge des Schutzobjektes sowie dessen Impedanzbelag bekannt sein.

Üblicherweise muss im Fehlerfall nicht lediglich das Vorhandensein eines Fehlers erkannt werden, sondern auch der genaue Ort bestimmt werden, an dem der Fehler aufgetreten ist. Hierfür sind mehrere Fehlerortungsverfahren bekannt. Eines davon basiert auf der Berechnung der Impedanz einer durch einen Fehler gebildeten Leiterschleife. Bei Kenntnis der übrigen Parameter kann durch Vergleich der gemessenen Impedanz mit einer bekannten Impedanz des fehlerfreien Schutzobjektes der Fehlerort bestimmt werden.

Für beide beschriebenen Anwendungsfälle ist die möglichst genaue Messung der Impedanz, bzw. der für die Bestimmung der Impedanz benötigten Ströme und Spannungen, erforderlich. Impedanzbestimmungen können jedoch durch verschiedene Einflussfaktoren verfälscht werden. Beispiele für solche Einflussfaktoren sind Gleichstromanteile (DC-Komponenten) im gemessenen Strom, Spannungsverfälschungen durch kapazitive Spannungswandler oder der Einfluss von Lichtbögen als Fehlerübergangswiderstand.

Für einige Fehlerquellen existieren bereits Korrekturmaßnahmen, z.B. wird eine Korrektur zu Eliminierung der Gleichstromanteile im Strom durchgeführt oder es werden Maßnahmen zur Spannungskorrektur beim Einsatz kapazitiver Spannungswandler getroffen. Aus einem brennenden Lichtbogen herrührende Impedanz-Messfehler werden bisher nicht korrigiert. Lichtbögen entstehen an der Stelle eines Fehler, wenn eine Überschlagsspannung in einem Zwischenraum zwischen zwei Leitern oder einem Leiter und Erde ausreichend groß ist, um aus dem im Zwischenraum befindlichen Gas ein elektrisch leitendes Plasma zu erzeugen und dieses zu zünden. Der elektrische Fehlerstrom fließt dann über den Lichtbogen und überbrückt damit den Zwischenraum.

Der Übergangswiderstand eines Lichtbogens wird bisher als rein ohmscher Anteil angesehen. Für die genannten Schutzfunktionen (Fehlerorter bzw. Distanschutz) wird jedoch im Wesentlichen der Reaktanzanteil der Impedanz betrachtet. Dieser wird jedoch verfälscht, z.B. da eine Zeigerberechnung der Spannung aufgrund der Zündspitze des Lichtbogens einen voreilender Sinus ermittelt.

Dadurch entstehen teils gravierende Messfehler, die sich signifikant auf die Bestimmung der Impedanz und die Funktion der darauf beruhenden Funktionen eines Schutzgerätes auswirkt.

Der Erfindung liegt daher die Aufgabe zugrunde, die Bestimmung einer Impedanz mit höherer Genauigkeit durchführen zu können.

Diese Aufgabe wird erfindungsgemäß durch ein Verfahren der eingangs genannten Art gelöst, bei dem ein während des Fehlers gemessener Spannungsverlauf durch einen korrigierten Spannungsverlauf ersetzt wird und die Fehlerimpedanz unter Verwendung des korrigierten Spannungsverlaufs bestimmt wird.

Mit dem erfindungsgemäßen Verfahren kann somit eine genauere Bestimmung einer Fehlerimpedanz erreicht werden, indem als der zur Bestimmung der Fehlerimpedanz herangezogene Spannungsverlauf ein korrigierter Spannungsverlauf verwendet wird. Es hat sich nämlich gezeigt, dass durch den während des Fehlers zündenden und erlöschenden Lichtbogen der gemessene Verlauf der Spannung derart beeinträchtigt wird, dass sich ein signifikanter Messfehler bei der Ermittlung der Fehlerspannung - und damit auch der daraus bestimmten Fehlerimpedanz - einstellen kann. Üblicherweise führen nämlich dem ungestörten Messsignal überlagerte Spannungsspitzen, die aus dem Zünden und Erlöschen des Lichtbogens herrühren, zu einem zu hohen Wert einer ermittelten Fehlerspannung und daraus resultierend einem zu hohen Wert einer Fehlerimpedanz. Auf die Fehlerimpedanz zurückgreifende Funktionen von Schutzgeräten, wie die Distanzschutzfunktion und/oder die Fehlerortungsfunktion, können auf dieser Basis zu falschen Ergebnissen gelangen. Durch das Ersetzen des gemessenen Spannungsverlaufs durch einen korrigierten Spannungsverlauf lässt sich die Fehlerimpedanz mit der benötigten Genauigkeit ermitteln, so dass fehlerhafte Ergebnisse der genannten Funktionen vermieden werden können.

Eine vorteilhafte Ausführungsform des erfindungsgemäßen Verfahrens sieht vor, dass das korrigierte Spannungssignal einen sinusförmigen Verlauf aufweist.

Da das ungestörte - also durch den Lichtbogen unbeeinflusste - Spannungssignal idealerweise einen sinusförmigen Verlauf haben müsste, lässt sich der gemessene Spannungsverlauf mit einem korrigierten Spannungsverlauf auf Basis eines Sinussignals am besten ersetzen.

Eine weitere vorteilhafte Ausführungsform des erfindungsgemäßen Verfahrens sieht vor, dass charakteristische Merkmale des gemessenen Spannungsverlaufs zur Bildung des korrigierten Spannungsverlaufs herangezogen werden.

Damit werden vorteilhaft bestimmte Merkmale des gemessenen Spannungsverlaufs in die Bildung des korrigierten Spannungsverlaufs einbezogen, so dass der korrigierte Spannungsverlauf so weit wie möglich einem fiktiven ungestörten Verlauf der gemessenen Spannung nachgebildet wird. Die charakteristischen Merkmale können dabei durch analytische Verfahren oder Mustererkennungsverfahren, die beispielsweise durch eine künstliche Intelligenz gestützt werden, erkannt werden.

Konkret kann in diesem Zusammenhang z.B. vorgesehen sein, dass als charakteristische Merkmale Nulldurchgänge des gemessenen Spannungsverlaufs verwendet werden, wobei der korrigierte Spannungsverlauf an denselben Stellen Nulldurchgänge aufweist wie der gemessene Spannungsverlauf.

Bei dieser Ausführungsform wird in vorteilhafter Weise die Erkenntnis ausgenutzt, dass die durch den Lichtbogen hervorgerufenen Störanteile den Verlauf der Spannung üblicherweise im Bereich von dessen Maximalwerten beeinträchtigt, da zum Zünden und Verlöschen des Lichtbogens bestimmte Schwellen über- bzw. unterschritten werden müssen.

Alternativ oder zusätzlich kann auch vorgesehen sein, dass als charakteristische Merkmale sinusförmige Teilverläufe des gemessenen Spannungsverlaufs verwendet werden, wobei der korrigierte Spannungsverlauf an die sinusförmigen Teilverläufe angepasst wird.

Gemäß dieser Ausführungsform werden für die Bildung des korrigierten Spannungsverlaufs insbesondere solche Teile des gemessenen Spannungsverlaufs herangezogen, bei denen der erwartete sinusförmige Verlauf der Spannung noch sichtbar ist, die also nicht von durch den Lichtbogen hervorgerufenen Störungen überlagert sind. Üblicherweise liegen solche Teilbereiche in Gebieten um den Nulldurchgang des gemessenen Spannungsverlaufs. Insbesondere können dabei Teilbereiche der zweiten Halbwelle herangezogen werden, da hier der Lichtbogen bereits gezündet hat.

Eine weitere vorteilhafte Ausführungsform des erfindungsgemäßen Verfahrens sieht vor, dass unter Verwendung des korrigierten Spanungsverlaufs Spannungszeiger bestimmt werden, unter Verwendung des gemessenen Stroms Stromzeiger bestimmt werden, und die Fehlerimpedanz aus den Spannungszeigern und den Stromzeigern bestimmt wird.

Zeigerwerte, also Messwerte, die eine Angabe über Amplitude und Phasenwinkel der jeweiligen Messgröße beinhalten, eignen sich nämlich besonders gut zur Bestimmung der Impedanzen.

Schließlich kann gemäß einer weiteren vorteilhaften Ausführungsform des erfindungsgemäßen Verfahrens vorgesehen sein, dass der während des Fehlers gemessene Spannungsverlauf daraufhin untersucht wird, ob er auf einen vorliegenden Lichtbogen hinweist, und der korrigierte Spannungsverlauf nur dann gebildet wird, wenn ein Lichtbogen vorliegt.

Bei dieser Ausführungsform kann erreicht werden, dass eine Korrektur des Spannungsverlaufs nur dann durchgeführt wird, wenn sie tatsächlich notwendig ist, nämlich wenn ein Lichtbogen tatsächlich vorliegt. Die Untersuchung auf das Vorliegen eines Lichtbogens kann beispielsweise durch analytische Betrachtung des Verlaufs der gemessenen Spannung durchgeführt werden. Weist der Verlauf Spitzen auf, die auf das Zünden und Erlöschen eines Lichtbogens hinweisen, so wird von einem vorliegenden Lichtbogen ausgegangen. Die Untersuchung kann auch durch eine mittels einer künstlichen Intelligenz gestützte Mustererkennung erfolgen.

Die oben genannte Aufgabe wird auch durch eine Einrichtung zur Bestimmung einer Fehlerimpedanz gelöst, mit einer Messanordnung, die dazu eingerichtet ist, im Fall eines Fehlers bezüglich eines Schutzobjektes eines elektrischen Energieversorgungsnetzes während des Fehlers auftretende Ströme und Spannungen zu erfassen, und einer Recheneinheit, die dazu eingerichtet ist, die erfassten Ströme und Spannungen zur Bestimmung der Fehlerimpedanz heranzuziehen.

Erfindungsgemäß ist vorgesehen, dass die Einrichtung zur Durchführung eines Verfahrens gemäß einem der Ansprüche 1 - 7 eingerichtet ist.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Konkret kann schließlich vorgesehen sein, dass die Einrichtung in ein Schutzgerät zur Überwachung des Schutzobjektes integriert ist. Außerdem kann die Erfindung in eine Fehlerortungseinrichtung integriert sein, die offline, also nach Eintritt des Fehlers, den Fehlerort bestimmt.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

### Hierzu zeigen

- Figur 1: eine schematische Ansicht eines Distanzschutzsystems zur Überwachung einer Leitung eines Energieversorgungsnetzes;
- Figur 2: ein beispielhafter gemessener Spannungsverlauf während eines Fehlers mit einem Lichtbogen;
- Figur 3: ein aus dem gemessenen Spannungsverlauf der Figur 2 sowie einem entsprechenden Stromverlauf resultierender Verlauf einer Fehlerimpedanz;
- Figur 4: ein Diagramm zur Erläuterung der Bildung eines korrigierten Spannungsverlaufs;
- Figur 5: ein Vergleich von mit dem gemessenen und dem korrigierten Spannungsverlauf bestimmten Fehlerimpedanzen; und
- Figur 6: ein Schutzgerät mit einem Ausführungsbeispiel einer Einrichtung zur Bestimmung einer Fehlerimpedanz.

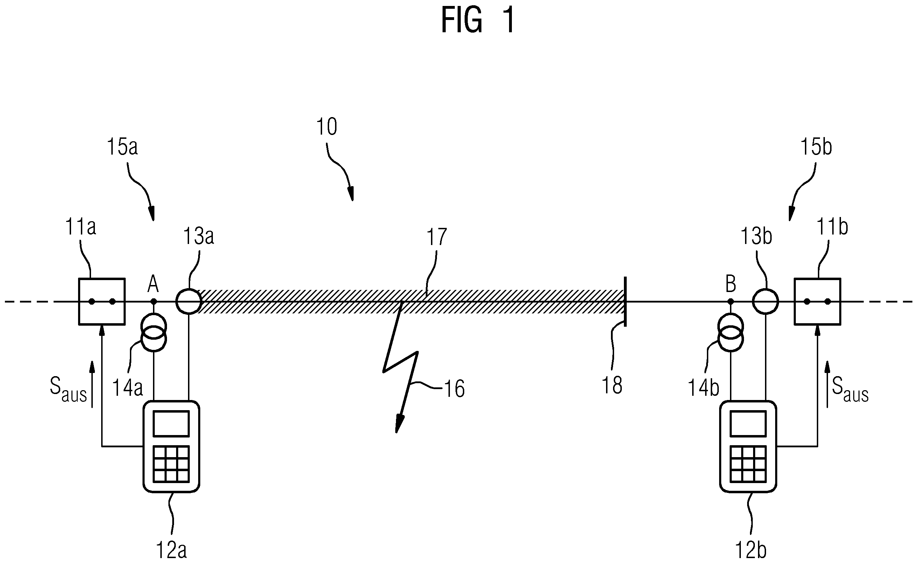

Figur 1 zeigt ein Schutzobjekt 10 in Form einer Leitung (Freileitung oder Kabel) eines ansonsten nicht näher dargestellten mehrphasigen elektrischen Energieversorgungsnetzes. Die Leitung wird an ihren beiden Enden A und B von Leistungsschaltern 11a und 11b begrenzt, über die im Fehlerfall eine Abschaltung der betroffenen Phasenleiter der Leitung vorgenommen werden kann. Zu diesem Zweck sind an den Leitungsenden A und B an Messstellen 15a und 15b elektrische Schutzgeräte 12a und 12b vorgesehen. Diesen werden an den jeweiligen Messstellen 15a, 15b mittels lediglich schematisch dargestellten Stromwandlern 13a, 13b und Spannungswandlern 14a, 14b aufgenommene Strom- und Spannungssignale zugeführt.

Die Schutzgeräte 12a, 12b führen mittels einer A/D-Wandlung eine Abtastung der Strom- und Spannungssignale durch und führen für die so erzeugten Strom- und Spannungsabtastwerte eine Fehlerauswertung durch, um eventuelle Kurzschlüsse 16 auf der Leitung 10 erkennen zu können. Bei einem solchen Kurzschluss 16 kann es sich entweder um einen einpoligen Kurzschluss zwischen einem Phasenleiter und Erde oder um einen zwei- oder mehrpoligen Kurzschluss mit Beteiligung mehrerer Phasenleiter handeln. Ergibt die Fehlerauswertung einen Kurzschluss 16 auf der Leitung, so wird ein Auslösesignal Sₐᵤₛ erzeugt und dem jeweiligen Leistungsschalter 11a, 11b zugeführt, um diesen zum Öffnen seiner Schaltkontakte zu veranlassen und so den/die von dem Kurzschluss 16 betroffenen Phasenleiter vom übrigen Energieversorgungsnetz abzutrennen.

Eine solche Fehlerauswertung anhand lediglich an einem Ende aufgenommener Strom- und Spannungsabtastwerte kann üblicherweise nicht für die komplette Leitungslänge durchgeführt werden, da die an einer Messstelle, z. B. der Messstelle 15a an dem Leitungsende A, ermittelten Abtastwerte im Falle eines in der Nähe des jeweils anderen Leitungsendes, beispielsweise des Leitungsendes B, liegenden Kurzschlusses aufgrund der hohen Leitungsimpedanz von der Messstelle bis zur Fehlerstelle nur sehr ungenau erfasst werden können. Aus diesem Grund stellt man in den Schutzgeräten 12a, 12b üblicherweise sogenannte Überwachungs- oder Schutzzonen ein, die diejenige Leitungslänge beginnend an der jeweiligen Messstelle 15a, 15b angeben, die von dem Schutzgerät 12a bzw. 12b effektiv überwacht wird. In Figur 1 ist eine solche Überwachungszone 17 schematisch durch eine Schraffierung eines von dem Schutzgerät 12a überwachten Teils der Leitung 10 dargestellt. Die Länge einer Überwachungszone wird üblicherweise als Parameter in dem jeweiligen Schutzgerät 12a, 12b in Prozent der Leitungslänge vorgegeben; beispielsweise kann eine Überwachungszone 85% der gesamten Länge der Leitung 10 betragen. Das Ende 18 der jeweiligen Schutzzone 17 wird auch als sogenannte Kippgrenze bezeichnet.

Zur Durchführung der Fehlerauswertung weisen die Schutzgeräte Einrichtungen zur Bestimmung einer Fehlerimpedanz auf, die mit den aufgenommenen Strom- und Spannungswerten eine Fehlerimpedanz berechnet. Dabei wird die Impedanz einer durch den Kurzschluss 16 gebildeten Fehlerschleife bestimmt. In diese Impedanz geht außer Parametern der Leitung, insbesondere deren Impedanzbelag, auch der Übergangswiderstand an der Fehlerstelle ein. Sofern an der Fehlerstelle ein Lichtbogen brennt, beeinflusst dieser die Messung.

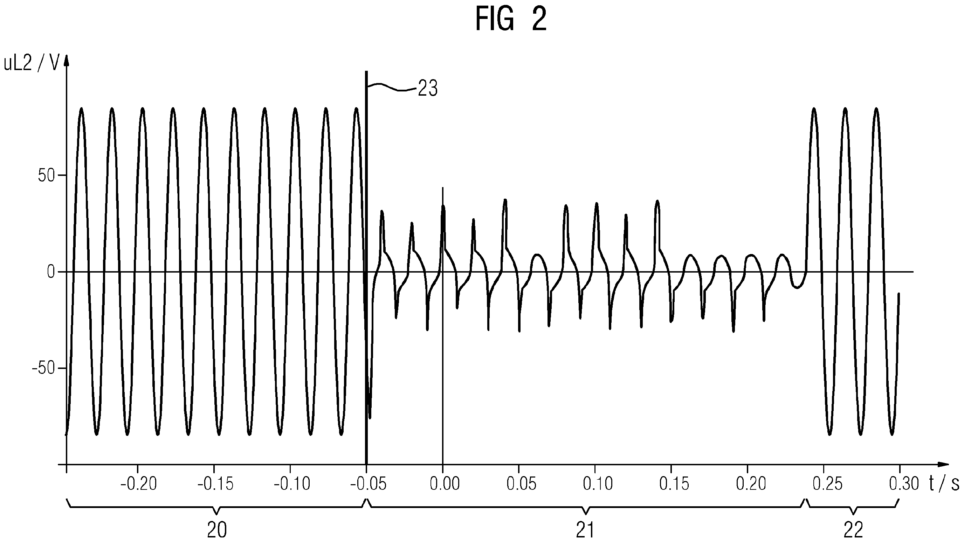

Dies sei am Beispiel der Figur 2 erläutert. Figur 2 zeigt den Verlauf der an einem Ende eines Schutzobjektes gemessenen Spannung vor (Bereich 20), während (Bereich 21) und nach (Bereich 22) einem Fehler. Der Zeitpunkt des Fehlereintritts ist mit dem Bezugszeichen 23 gekennzeichnet. Man erkennt einerseits einen Einbruch der Spannung aufgrund des Fehlers. Der vor und nach dem Fehler sinusförmige Verlauf der Spannung wird zudem während des Fehlers durch Störungen überlagert, die durch das Zünden und Erlöschen eines Lichtbogens hervorgerufen werden. Sie zeigen sich in Form ausgeprägter Spitzen im gemessenen Spannungsverlauf während des Fehlers.

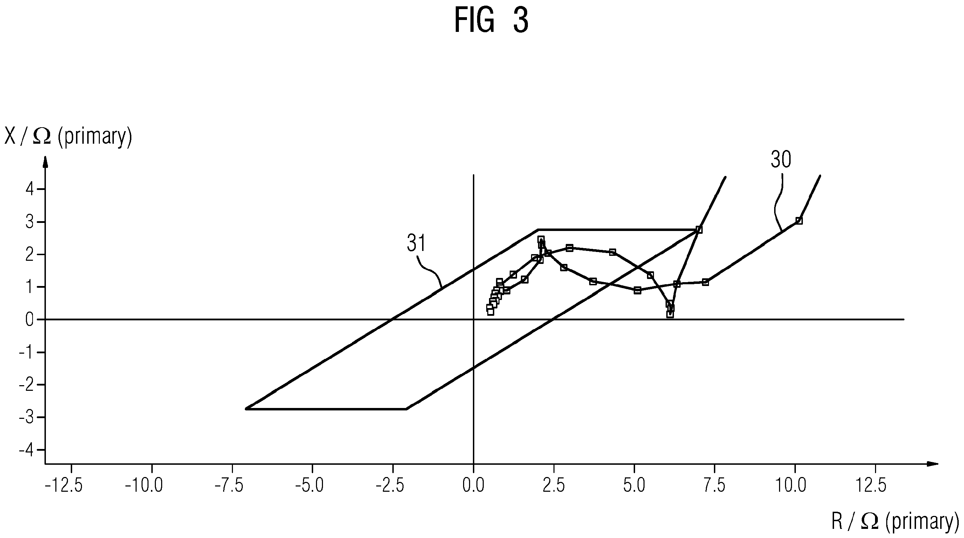

Wird dieser durch Störungen überlagerte gemessene Spannungsverlauf als Grundlage der Berechnung der Fehlerimpedanz verwendet, so ergeben sich im Mittel zu hohe Werte, die aufgrund der Spannungsspitzen hohen Schwankungen ausgesetzt sind. Dies zeigt Figur 3, in der der Verlauf der unter Verwendung des gemessenen Spannungsverlaufs bestimmten Fehlerimpedanz 30 in einer komplexen Zahlenebene dargestellt ist. Aufgetragen ist die Reaktanz X über der Resistanz R als Bestandteile der Impedanz Z. Im Diagramm der Figur 3 ist außerdem ein Auslösepolygon 31 einer Distanzschutzfunktion gezeigt. Dieses Auslösepolygon ist lediglich beispielhaft zu verstehen, es können selbstverständlich zur Bewertung der Fehlerimpedanz anders ausgestaltete und/oder für unterschiedliche Schutzzonen gestaffelte Auslösepolygone verwendet werden. Wenn die Fehlerimpedanz für eine gewisse Dauer innerhalb des Auslösepolygons 31 liegt, soll ein Fehler erkannt und damit ein Schalter ausgelöst werden. Man erkennt, dass durch die deutlichen Schwankungen der Fehlerimpedanz eine eindeutige Entscheidung bzgl. des Vorliegens eines Fehlers erschwert wird und eine Distanzschutzfunktion damit verzögert auslösen würde. Ebenso würde ein mit der Fehlerimpedanz arbeitender Fehlerorter einen unrichtigen Wert für die Fehlerentfernung liefern.

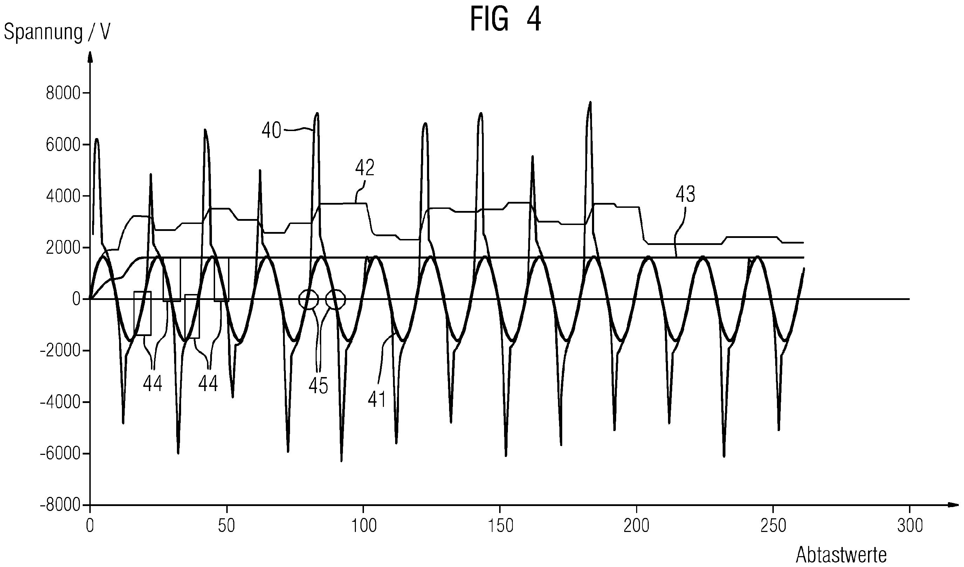

Die zu Figuren 2 und 3 gemachten Ausführungen zeigen deutlich, dass der gemessene Spannungsverlauf bei Vorliegen eines Lichtbogens zu inkorrekten Ergebnissen bei der Bestimmung der Fehlerimpedanz führen kann. Daher wird vorgeschlagen, den gemessenen Verlauf durch einen korrigierten Spannungsverlauf zu ersetzen. Dies wird anhand der Figur 4 näher erläutert.

In dem Diagramm der Figur 4 ist einerseits der gemessene Spannungsverlauf 40 während des Fehlers dargestellt. Mit der Kurve 42 ist zur Illustration der Verlauf einer zu dem gemessenen Spannungsverlauf 40 gehörenden Amplitude der gemessenen Spannung dargestellt. Außerdem zeigt Figur 4 einen korrigierten Spannungsverlauf 41, der die Störeinflüsse des Lichtbogens eliminiert und anstelle des gemessenen Spannungsverlaufs 40 zur Bestimmung der Fehlerimpedanz herangezogen werden soll. Wiederum ist eine Kurve 43 eingetragen, die die Amplitude des korrigierten Spanungsverlaufs angibt. Man erkennt, dass die Kurve 43 deutlich niedriger und stabiler verläuft als die Kurve 42.

Bei der Bildung des korrigierten Spannungsverlaufs 41 wird wie folgt vorgegangen. Zunächst wird ein sinusförmiges Signal verwendet, da idealerweise - also ohne Überlagerungen durch Störeinflüsse des Lichtbogens - ein sinusförmiger Spannungsverlauf zu erwarten wäre. Zur Anpassung dieses sinusförmigen Signales können charakteristische Merkmale des gemessenen Spanungsverlaufs herangezogen werden. Damit kann die Ähnlichkeit zwischen dem korrigierten Spannungsverlauf und dem gemessenen Spannungsverlauf unter gleichzeitiger Eliminierung der Störanteile erhöht werden. Als ein charakteristisches Merkmal des gemessenen Spanungsverlaufs können dessen Nulldurchgänge verwendet werden, von denen in Figur 4 beispielhaft die Nulldurchgänge 45 hervorgehoben sind. Da im Bereich der Nulldurchgänge eine Beeinflussung durch den Lichtbogen als gering anzunehmen ist, sollten die Nulldurchgänge des korrigierten Spannungsverlaufs an dieselben Stellen gesetzt werden. Damit lässt sich die Frequenz bzw. Periodendauer des korrigierten Signals festlegen. Als ein zusätzliches oder alternatives charakteristisches Merkmal können sinusförmige Teilverläufe des gemessenen Spannungsverlaufs verwendet werden. Da sich der Lichtbogen nicht in allen Teilabschnitten des gemessenen Spannungsverlaufs in gleicher Intensität auswirkt, kann erwartet werden, dass weitgehend unbeeinflusste Teilabschnitte vorliegen, die den idealerweise vorhandenen sinusförmigen Verlauf des Spannungssignals aufweisen. Solche Teilabschnitte sind üblicherweise in der Nähe des Nulldurchgangs zu erwarten, wo Zünd- bzw. Erlöschensvorgänge des Lichtbogens einen geringeren Einfluss haben. Hierfür kann insbesondere die zweite Halbwelle des gemessenen Spannungsverlaufs herangezogen werden. In Figur 4 sind solche sinusförmigen Teilverläufe mit dem Bezugszeichen 44 beispielhaft hervorgehoben.

Die Anpassung des korrigierten Spanungsverlaufs kann mit analytischen Methoden und/oder Mustererkennungen aus dem Bereich der künstlichen Intelligenz vorgenommen werden.

Der ermittelte korrigierte Spannungsverlauf wird daraufhin anstelle des gemessenen Spannungsverlaufs verwendet, um die Fehlerimpedanz zu bilden.

Die Fehlerimpedanz kann hierbei beispielsweise auf Momentanwertbasis oder auf der Basis von Zeigermesswerten aus den Messgrößen Strom und Spannung ermittelt werden. Bei der Verwendung von Zeigermessgrößen können bevorzugt digitale Filter (z.B. DFT-Filter - Discrete Fourier Transformation) eingesetzt werden.

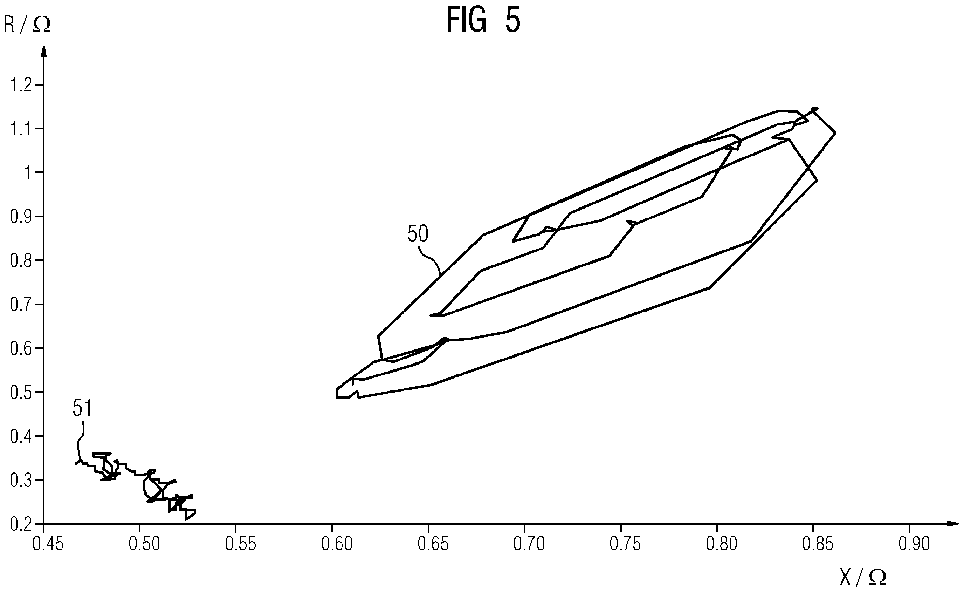

Die auf diese Weise gebildete Fehlerimpedanz kann als Basis für die Funktionen eines Distanzschutzes und/oder eines Fehlerorters verwendet werden und liefert signifikant genauere Ergebnisse. Dies ist in Figur 5 illustriert, in der die Verläufe von Fehlerimpedanzen miteinander verglichen werden, die einerseits mit dem unkorrigierten gemessenen Spannungsverlauf (Kurve 50) und andererseits mit dem korrigierten Spannungsverlauf (Kurve 51) bestimmt worden sind. Man erkennt, dass die Kurve 51 bei signifikant niedrigeren Werten einen deutlich stabileren Verlauf aufweist als die Kurve 50. Damit kann eine schnellere und zuverlässigere Bestimmung über das Vorliegen eines Fehlers mit einem Distanzschutzverfahren getroffen werden. Auch die Ermittlung eines Fehlerortes kann mit signifikant höherer Genauigkeit erfolgen.

Da nicht alle Fehler mit dem Auftreten eines Lichtbogens verbunden sind, kann in vorteilhafter Weise eine Prüfung erfolgen, ob der gemessene Spannungsverlauf überhaupt Anzeichen eines Lichtbogens aufweist. Solche Anzeichen können insbesondere die charakteristischen Spitzen im Verlauf sein, die durch das Zünden und Erlöschen des Lichtbogens entstehen. Eine solche Erkennung kann analytisch oder durch Mustererkennung mit einer künstlichen Intelligenz erfolgen. Sobald Anzeichen eines Lichtbogens erkannt werden, wird anstelle des gemessenen Spannungsverlaufs der korrigierte Spannungsverlauf verwendet. Liegen solche Anzeichen hingegen nicht vor, wird der gemessene Spannungsverlauf zur Bildung der Fehlerimpedanz verwendet, da davon ausgegangen werden kann, dass dieser nicht durch Störeinflüsse eines Lichtbogens überlagert ist.

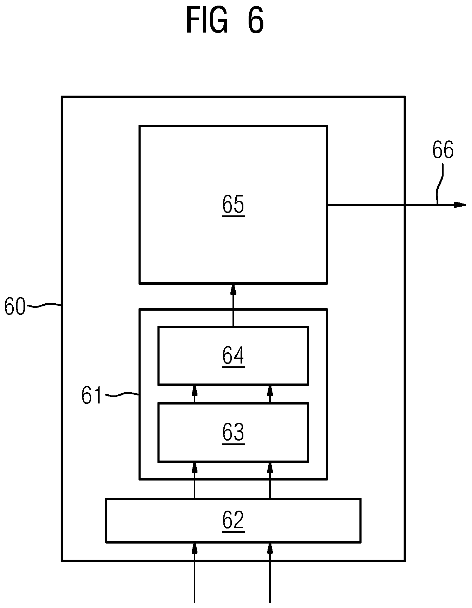

Figur 6 zeigt schließlich ein Schutzgerät 60 mit einer Einrichtung 61 zur Bestimmung einer Fehlerimpedanz. Das Schutzgerät kann eine Messwerterfassungseinrichtung 62 aufweisen, die Signale von Strömen und Spannungen erfasst und an eine Messanordnung 63 der Einrichtung 61 weiterleitet. Messwerterfassungseinrichtung 62 und Messanordnung 63 können alternativ auch durch eine einzelne Einheit gebildet sein. Die Einrichtung 61 weist eine Recheneinheit 64 auf, die aus den Strom- und Spannungsverläufen die Fehlerimpedanz berechnet. Die Bildung des korrigierten Spannungsverlaufs kann dabei in der Messanordnung 63 oder in der Recheneinheit 64 stattfinden. Auch kann dort die Erkennung stattfinden, ob ein Lichtbogen vorliegt und überhaupt eine Bildung des korrigierten Spannungsverlaufs nötig ist. Die ermittelte Fehlerimpedanz wird von der Recheneinheit 64 an eine Schutzeinheit 65 des Schutzgerätes 60 abgegeben, wo sie zur Ausführung von Schutzfunktionen, insbesondere Distanzschutz und/oder Fehlerorter, verwendet wird. Ggf. wird an Stelle 66 ein Auslösesignal zur Ansteuerung eines Schalters ausgegeben.

Die Einrichtung 61 kann als selbständige Komponente ausgebildet sein oder in das Schutzgerät 60 integriert sein. Bei Integration in das Schutzgerät kann sie in einem eigenständigen Modul oder in einem gemeinsam genutzten Modul, z.B. einer CPU oder einem ASIC bzw. FPGA implementiert sein, in dem auch andere Funktionen, insbesondere Messfunktionen und Schutzfunktionen des Schutzgerätes durchgeführt werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Verfahren zum Bestimmen einer Fehlerimpedanz, bei dem im Fall eines Fehlers bezüglich eines Schutzobjektes (10) eines elektrischen Energieversorgungsnetzes an einem Ende (11a) des Schutzobjektes während des Fehlers auftretende Ströme und Spannungen erfasst und zur Bestimmung der Fehlerimpedanz herangezogen werden,
**dadurch gekennzeichnet, dass**
- ein während des Fehlers gemessener Spannungsverlauf (40) durch einen korrigierten Spannungsverlauf (41) ersetzt wird; und
- die Fehlerimpedanz unter Verwendung des korrigierten Spannungsverlaufs (41) bestimmt wird.

2. Verfahren nach Anspruch 1,
**dadurch gekennzeichnet, dass**
- der korrigierte Spannungsverlauf (41) einen sinusförmigen Verlauf aufweist.

3. Verfahren nach Anspruch 2,
**dadurch gekennzeichnet, dass**
- charakteristische Merkmale des gemessenen Spannungsverlaufs (40) zur Bildung des korrigierten Spannungsverlaufs (41) herangezogen werden.

4. Verfahren nach Anspruch 3,
**dadurch gekennzeichnet, dass**
- als charakteristische Merkmale Nulldurchgänge (45) des gemessenen Spannungsverlaufs (40) derart verwendet werden, dass der korrigierte Spannungsverlauf (41) an denselben Stellen Nulldurchgänge (45) aufweist wie der gemessene Spannungsverlauf (40).

5. Verfahren nach Anspruch 3 oder 4,
**dadurch gekennzeichnet, dass**
- als charakteristische Merkmale sinusförmige Teilverläufe (44) des gemessenen Spannungsverlaufs (40) derart verwendet werden, dass der korrigierte Spannungsverlauf (41) an die sinusförmigen Teilverläufe (44) angepasst wird.

6. Verfahren nach einem der vorangehenden Ansprüche,
**dadurch gekennzeichnet, dass**
- unter Verwendung des korrigierten Spanungsverlaufs (41) Spannungszeiger bestimmt werden;
- unter Verwendung des gemessenen Stroms Stromzeiger bestimmt werden; und
- die Fehlerimpedanz aus den Spannungszeigern und den Stromzeigern bestimmt wird.

7. Verfahren nach einem der vorangehenden Ansprüche,
**dadurch gekennzeichnet, dass**
- der während des Fehlers gemessene Spannungsverlauf (40) daraufhin untersucht wird, ob er auf einen vorliegenden Lichtbogen hinweist; und
- der korrigierte Spannungsverlauf (41) nur dann gebildet wird, wenn ein Lichtbogen vorliegt.

8. Einrichtung (61) zur Bestimmung einer Fehlerimpedanz, mit
- einer Messanordnung (63), die dazu eingerichtet ist, im Fall eines Fehlers bezüglich eines Schutzobjektes (10) eines elektrischen Energieversorgungsnetzes während des Fehlers auftretende Ströme und Spannungen zu erfassen; und
- einer Recheneinheit (64), die dazu eingerichtet ist, die erfassten Ströme und Spannungen zur Bestimmung der Fehlerimpedanz heranzuziehen,
**dadurch gekennzeichnet, dass**
- die Einrichtung (61) zur Durchführung eines Verfahrens gemäß einem der Ansprüche 1 - 7 eingerichtet ist.

9. Einrichtung (61) nach Anspruch 8,
**dadurch gekennzeichnet, dass**
- die Einrichtung (61) in ein Schutzgerät (60) zur Überwachung des Schutzobjektes (10) oder in eine Einrichtung zur Fehlerortung integriert ist.
